# EUROPEAN PATENT APPLICATION

(11) **EP 4 462 563 A1**
(43) Date of publication of application: **13.11.2024**
(21) Application number: 23873000.6
(22) Date of filing: 25.09.2023
(51) Int. Cl.: H01M 50/24, H01M 50/209

(54) **PACK CASE HAVING IMPROVED STRUCTURE FOR PREVENTING THERMAL PROPAGATION**

(30) Priority: 30.09.2022 KR 20220124853
(71) Applicant: LG Energy Solution, Ltd., Seoul 07335 (KR)
(72) Inventor: KIM, Dae Gil, Daejeon 34122 (KR); CHOI, Jong Hwa, Daejeon 34122 (KR); LIM, Chae Won, Daejeon 34122 (KR); LEE, Hyoung Suk, Daejeon 34122 (KR)
(74) Representative: Plasseraud IP
(86) International application number: PCT/KR2023/014603
(87) International publication number: WO 2024/071883

(57) **Abstract**

A pack case includes a base plate forming a bottom surface; a side beam coupled along the edges of the front, rear, left, and right sides of the base plate to form an accommodation space; a top cover coupled to the side beam to cover the upper surface of the accommodation space; and a lid bracket coupled to the top cover and side beam.

## Description

### [Technical Field]

The present invention relates to a pack case that accommodates a plurality of battery modules, wherein the structural rigidity of the pack case is enhanced to withstand an increase in the internal pressure of the pack case for an extended period of time due to a thermal runaway phenomenon generated by the battery cells in the battery modules.

This application claims the benefit of priority to Korean Patent Application No. 10-2022-0124853, filed on September 30, 2022, the disclosure of which is incorporated herein by reference in its entirety.

### [Background Technology of the Invention]

Unlike primary batteries, secondary batteries can be recharged, and they have been heavily researched and developed in recent years due to their potential for miniaturization and large capacity. The demand for secondary batteries as an energy source is increasing rapidly due to the technological development and increasing demand for mobile devices, electric vehicles, and energy storage systems, which are emerging in response to the need for environmental protection.

Secondary batteries are categorized into coin-type cells, cylindrical cells, prismatic cells, and pouch-type cells based on the shape of the cell case. In a secondary battery, an electrode assembly mounted inside the battery case is a chargeable/dischargeable power generator consisting of a laminated structure of electrodes and separators.

Since secondary batteries are required for continuous use over a long period, it is necessary to effectively control the heat generated during the charging and discharging process. If the cooling of the secondary battery is not carried out smoothly, the temperature rise can lead to an increase in current, and the increase in current causes the temperature to rise again, creating a feedback chain reaction that eventually leads to the catastrophic condition of thermal runaway.

Additionally, when secondary batteries form a group in the form of modules or packs, the occurrence of thermal runaway in one secondary battery can lead to a thermal propagation phenomenon where the surrounding batteries get successively overheated. That is, when thermal runaway occurs in a battery module within the battery pack, a large amount of conductive dust, gas, and flames are emitted from the high-voltage terminals of the battery module. As a result, dust accumulates on the high-voltage terminals of other neighboring battery modules, and heat transfer by gas and flame triggers the phenomenon of thermal propagation.

The internal pressure of the battery pack increases due to thermal propagation inside the battery pack. A pack case that accommodates a plurality of battery modules can withstand a certain level of internal pressure and resist structural deformation. However, as thermal runaway and propagation progress, the internal pressure can rise to levels beyond which the pack case can handle.

When the internal pressure exceeds the structural rigidity limit of the pack case, the seams of the pack case eventually open, allowing the emission of high-temperature and highpressure dust, gas, and flames. This can lead to a fire hazard around the battery pack. Therefore, the higher the structural rigidity of the pack case, the more it can delay the spread of thermal propagation outside the battery pack.

To achieve such superior structural rigidity in the pack case, it is possible to configure the pack case from a thicker and stronger material, or to manufacture the pack case in a form that minimizes the number of seams, e.g. by cutting it out of a metal block. However, these methods can dramatically increase the production cost of the pack case, and the excessive increase in weight limits their application in fields where weight itself is critical, such as in automotive batteries.

### [Description of the Invention]

### [Technical Problem]

The objective of this invention is to provide a pack case that significantly enhances structural rigidity without substantially increasing the weight of the pack case.

However, the technical problems to be solved by the present invention are not limited to the above-described problem, and other problems not mentioned can be clearly understood by those skilled in the art from the following description of the present invention.

### [Technical Solution]

The present invention relates to a pack case, wherein in one example, it includes a base plate having a bottom surface; a plurality of side beams coupled along edges of a front side, a rear side, a left side, and a right side of the base plate to define an accommodation space; a top cover coupled to the plurality of side beams to cover the accommodation space; and a lid bracket coupled to the top cover and one side beam of the plurality of side beams.

In an exemplary embodiment of the present invention, the lid bracket may have a bent shape contacting an edge of the top cover and upper corners of the one side beam.

Furthermore, the lid bracket may be provided in plurality to correspond to the plurality of side beams.

Additionally, the lid bracket may be coupled to each of the top cover and the one side beam by a separable fastening member or by welding.

Moreover, the lid bracket may be coupled to the one side beam with the top cover by the separable fastening member.

Also, a gasket may be interposed between the plurality of side beams and the top cover.

Meanwhile, according to another exemplary embodiment of the present invention, it further includes a corner bracket coupled along a height direction at each corner where adjacent side beams of the plurality of side beams meet.

The corner bracket may have a bent shape that contacts the adjacent side beams of the plurality of side beams.

Additionally, each corner bracket may be coupled to the adjacent side beams by a separable fastening member or by welding.

Furthermore, a heat-resistant silicone may be interposed between the adjacent side beams of the plurality of side beams.

Also, a brazing material may be interposed between each corner bracket and each side beam.

### [Advantageous Effects]

The pack case of the present invention having the above configuration, emission of dust or gas is more effectively suppressed by strengthening the fixing force of the top cover and/or the side beam by the lid bracket and/or the corner bracket even when the internal pressure rises excessively due to thermal runaway occurring in the battery module mounted in the accommodation space and a large amount of conductive dust, gas, and flame being emitted.

In particular, the present invention has the advantage that the pressure resistance performance of the pack case can be improved by simply adding bent lid brackets and/or corner brackets without constructing the pack case with a thicker and stronger material, thereby reducing the manufacturing cost, process efficiency, and weight of the battery pack.

However, the technical effects that can be obtained through this invention are not limited to the effects mentioned above. Other effects not mentioned will be clearly understood by those skilled in the art from the following description of the invention.

### [Brief Description of the Drawings]

The following drawings accompanying this specification illustrate preferred exemplary embodiments of the present invention and are intended to serve as a further understanding of the technical ideas of the present invention in conjunction with the detailed description of the invention that follows, so the present invention is not to be construed as limited to what is shown in such drawings
FIG. 1 is a drawing illustrating an exemplary embodiment of a pack case according to the present invention.
FIG. 2 is a drawing illustrating an exemplary embodiment in which a lid bracket is mounted.
FIG. 3 is a cross-sectional view illustrating the mounting structure of the lid bracket.
FIG. 4 is a drawing illustrating an exemplary embodiment in which a corner bracket is mounted.
FIG. 5 is a drawing illustrating the state in which a corner bracket is mounted between the side beams.
FIG. 6 is a cross-sectional view illustrating an exemplary embodiment in which a heat-resistant silicone is interposed between the side beams.
FIG. 7 is a cross-sectional view illustrating an exemplary embodiment in which a brazing material is interposed between the corner bracket and the side beam.

### [Best Mode for Invention]

The present invention may have various modifications and various examples, and specific examples are illustrated in the drawings and described in detail in the description.

However, it should be understood that the present invention is not limited to specific embodiments, and includes all modifications, equivalents or alternatives within the spirit and technical scope of the present invention.

The terms "comprise," "include" and "have" are used herein to designate the presence of characteristics, numbers, steps, actions, components or members described in the specification or a combination thereof, and it should be understood that the possibility of the presence or addition of one or more other characteristics, numbers, steps, actions, components, members or a combination thereof is not excluded in advance.

In addition, when a part of a layer, a film, a region or a plate is disposed "on" another part, this includes not only a case in which one part is disposed "directly on" another part, but a case in which a third part is interposed there between. In contrast, when a part of a layer, a film, a region or a plate is disposed "under" another part, this includes not only a case in which one part is disposed "directly under" another part, but a case in which a third part is interposed there between. In addition, in this application, "on" may include not only a case of disposed on an upper part but also a case of disposed on a lower part.

The present invention relates to a pack case, which, in one example, includes a base plate forming a bottom surface, a side beam coupled along the edges of the front, rear, left, and right sides of the base plate to form an accommodation space, a top cover coupled to the side beam to cover the upper surface of the accommodation space, and a lid bracket coupled to the top cover and side beam.

In an exemplary embodiment of the present invention, the lid bracket forms a bent shape contacting both the edge of the top cover and the upper corners of the side beams.

In the pack case of the present invention equipped with such a configuration, leakage of dust and the like is more effectively suppressed by strengthening the fixing force of the top cover by the lid bracket even when the internal pressure rises excessively due to thermal runaway from the battery module mounted in the accommodation space, causing a large amount of conductive dust, gas, and flame to be emitted.

In particular, the present invention may improve the internal pressure performance of the pack case by adding a bent-shaped lid bracket, without the need for configuring the pack case with a thicker and stronger material, so there is an advantage of not imposing excessive burdens in terms of manufacturing costs, process efficiency, and the increase in weight of the battery pack.

### [Mode for Invention]

Hereinafter, specific embodiments of a pack case according to the present invention will be described in detail with reference to the accompanying drawings. For reference, the directions of front, back, up, down, left and right designating relative positions used in the following description are for the purpose of understanding the invention, and refer to the directions shown in the drawings unless otherwise specified.

### [First embodiment]

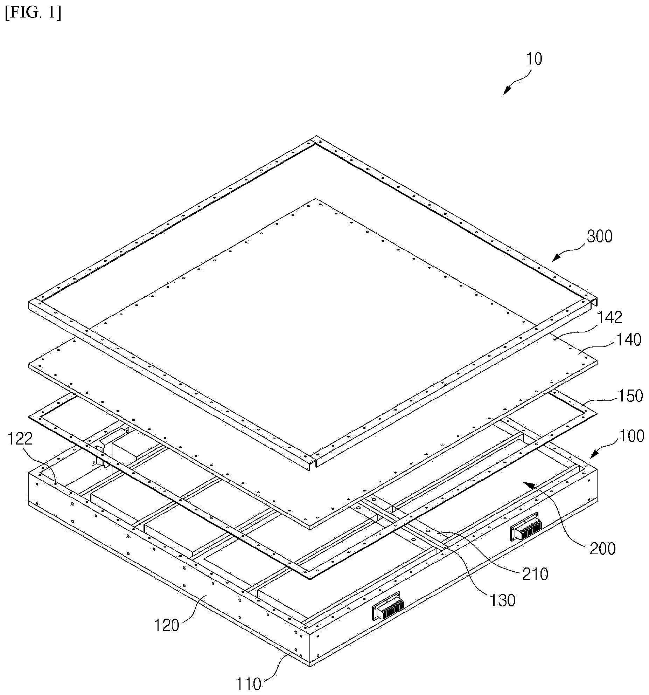

FIG. 1 is a drawing illustrating an exemplary embodiment of a pack case 100 according to the present invention. The pack case 100 refers to a casing of a battery pack 10 in which a plurality of battery modules 200 are mounted. The pack case 100 is framed to form a space for accommodating the plurality of battery modules 200, while protecting the mounted battery modules 200 and ensuring structural rigidity of the battery pack 10. The battery pack 10, exemplarily shown in FIG. 1, has a total of eight battery modules 200 mounted on it, with the fronts of the battery modules 200 arranged to face toward a center beam 130 that runs across the center of the pack case 100. High voltage terminals for connecting a busbar are arranged on the front of the battery modules 200, and a thermal barrier 210 is mounted on the battery modules 200 to protect them.

The pack case 100 includes a base plate 110 forming a bottom surface, and side beams 120 along the edges of the front, rear, left, and right sides of the base plate 110, respectively, that are coupled to form an accommodation space. To form the pack case 100 in a hexahedral shape, four side beams 120 are provided. Here, the side beams 120 forming the side walls of the pack case 100 may be referred to as front beams and rear beams, two of which may be referred to as front beams and rear beams, respectively, depending on the front and rear positioning defined for the battery pack 10.

Further, the pack case 100 includes a top cover 140 coupled to the side beams 120 to cover an upper surface of the accommodation space in which the battery module 200 is mounted. A gasket 150 may be disposed therebetween to seal a contact surface between the side covers and the top cover 140.

Prior art pack cases utilize a detachable fastening member 500 to attach the top cover 140 to the side beam 120, such as the bolt shown in FIG. 1. The bolt passes through a fastening hole 142 formed in the top cover 140 and is fastened to a tapped hole 122 formed in the top surface of the side beam 120.

According to this conventional structure, when the battery module 200 is operating normally, the fixing force of the fastening member 500 provides sufficient adhesion to the gasket 150 to maintain a good seal of the battery pack. However, when the internal pressure of the pack case 100 rises due to thermal runaway of the battery module 200, the pressure weakens the fixing force of the fastening member 500 and creates a gap between the gasket 150, allowing dust, gas, and flame to escape to the outside. Furthermore, oxygen is supplied to the gap in the top cover 140, causing the flame inside the pack case 100 to grow more intense.

The pack case 100 of the present invention includes a lid bracket 300 to enhance the fixing force of the top cover 140. The lid bracket 300 is coupled to the top cover 140 and the side beam 120, and in the embodiment shown, the lid bracket 300 has a bent shape that contacts both an edge of the top cover 140 and an upper corner of the side beam 120. This bent shape of the lid bracket 300 provides additional fixing force for the top cover 140 along the rim of the pack case 100 where the top cover 140 and the side beams 120 contact, with one bent surface coupled to the top cover 140 and the other bent surface coupled to the side beams 120.

Due to the additional fixing force by the lid bracket 300, even if the internal pressure of the pack case 100 rises excessively, the adhesion between the top cover 140 and the gasket 150 is maintained well, so that leakage of dust or gas is more effectively suppressed or delayed.

And, since the weight and volume of the lid bracket 300 itself is not very large, it is possible to improve the pressure resistance performance of the pack case 100 by simply adding a bent-shape lid bracket 300 without constructing the pack case 100 with a thicker and stronger material, so that there is no undue burden on the manufacturing cost, process efficiency, or weight increase of the battery pack 10.

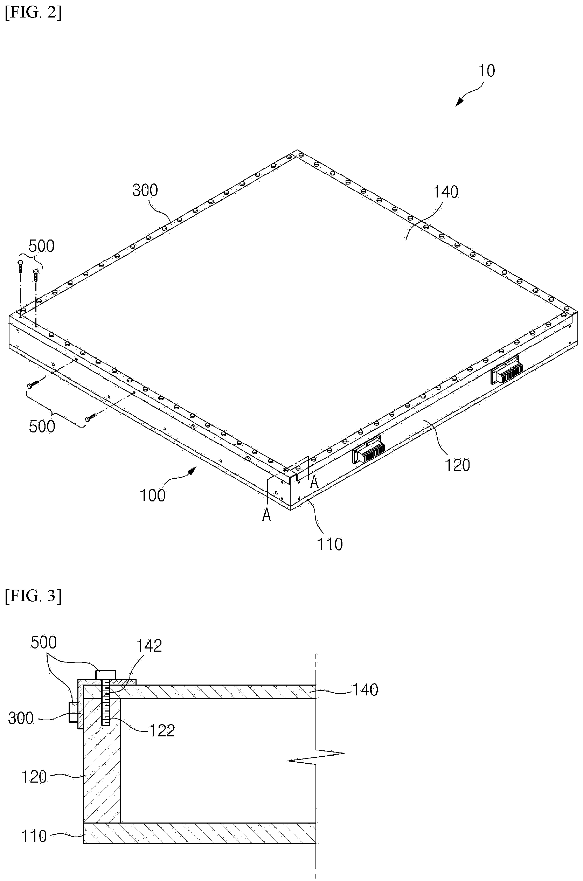

FIG. 2 is a drawing illustrating an exemplary embodiment of mounting the lid bracket 300. Referring to FIG. 2, a single lid bracket 300 is provided for each side beam 120. Because the lid brackets 300 is bent, it may be advantageous to assign one lid bracket 300 to each side beam 120 rather than having one side beam 120 spanning a plurality of side beams 120 to be coupled.

FIG. 3 is a cross-sectional view illustrating the mounting structure of the lid bracket 300. As mentioned above, the lid bracket 300 may be coupled to the top cover 140 and the side beam 120 using a detachable fastening member 500, such as the bolts shown in the drawing. In addition to such fastening member 500, the lid bracket 300 may also be mounted using welding. However, the use of the detachable fastening member 500 is advantageous in that it facilitates maintenance of the interior of the battery pack 10 by removing the lid bracket 300 and the top cover 140, and also improves workability because the lid bracket 300, together with the top cover 140, may be collectively fixed to the side beam 120 by the fastening member 500, as shown in FIG. 3.

### [Second embodiment]

A second embodiment of the present invention is an embodiment that can further enhance the pressure resistance performance of the pack case 100, and further includes a corner bracket 400 that reinforce the fastening structure between the side beams 120.

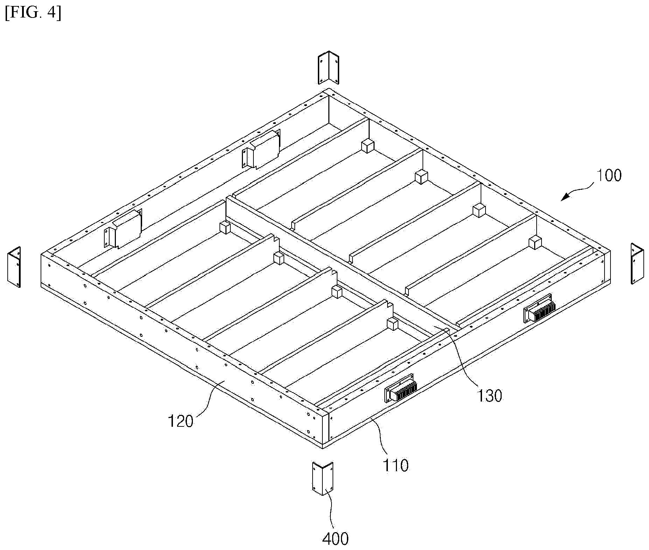

FIG. 4 is a drawing illustrating an exemplary embodiment of mounting a corner bracket 400, wherein the corner bracket 400 is coupled along the height direction of a corner where the side beams 120 butt against each other. Because the contact area between the side beams 120 is not very large, a separate gasket is generally not installed, but when the internal pressure rises due to thermal runaway, the side beams 120 will lift up between them, causing dust, gas, and the like to be emitted.

To prevent leakage between these side beams 120, corner brackets 400 are mounted. The corner bracket 400 has a bent shape that contacts both of the side beams 120 abutting each other on both sides, and strengthens the fixing force between the side beams 120 by coupling along the height direction of the corners where the side beams 120 contact each other.

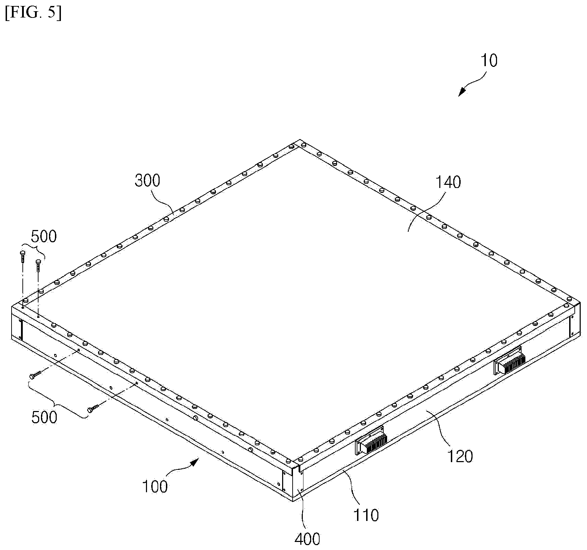

FIG. 5 illustrates a state in which the corner bracket 400 is mounted between the side beams 120, and as the fixing force between the side beams 120 is improved, the side beams 120 are less likely to spread apart even when strong internal pressure is applied, and thus, the emission of dust and gas from the space between the side beams 120 is suppressed.

And, while FIGS. 4 and 5 show the corner bracket 400 coupling to the side beam 120 by a detachable fastening member 500, it is also possible to join the corner bracket 400 to the side beam 120 by welding, as described in the first embodiment.

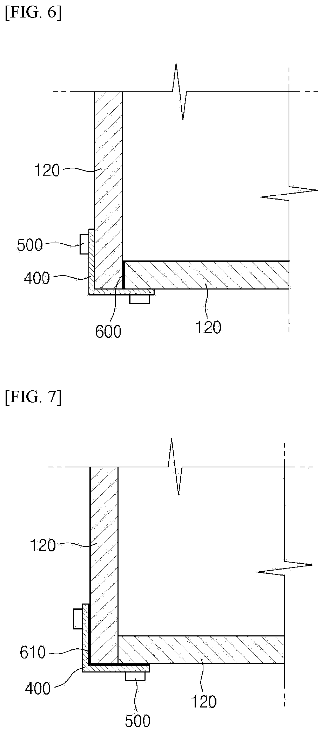

FIG. 6 is a cross-sectional view illustrating an exemplary embodiment in which a heat-resistant silicone 600 is interposed between side beams 120. In addition to the corner brackets 400 improving fixation of the height direction corners of the pack case 100, the contact surfaces between the side beams 120 may be provided with a heat-resistant silicone 600. The heat-resistant silicone 600 helps to maintain good contact between the side beams 120 even in high temperature environments, which further suppresses leakage of the battery module 200.

And, to improve the adhesion between the corner bracket 400 and the side beam 120, the contact surface between the corner bracket 400 and the side beam 120 may be interposed with a brazing material 610. That is, a brazing treatment may be performed on the contact surface between the corner bracket 400 and the side beam 120. By embedding a thin light brazing material on the inner surface of the corner bracket 400, fastening it to the side beam 120, and applying heat at an appropriate temperature, the brazing material 610 can be interposed on the contact surface between the corner bracket 400 and the side beam 120, and by the brazing material 610 solidifying after melting and filling the gap, the effect of further strengthening the fixing force of the corner bracket 400 as well as improving the airtightness can be obtained.

The present invention has been described in more detail above with reference to the drawings and embodiments. However, it is to be understood that the configurations shown in the drawings or embodiments described herein are only one embodiment of the invention and do not represent all of the technical ideas of the invention, and that there may be various equivalents and modifications that may replace them at the time of filing the present application.

### [Reference numerals]

10: BATTERY PACK
100: PACK CASE
110: BASE PLATE
120: SIDE BEAM
122: TAPPED HOLE
130: CENTER BEAM
140: TOP COVER
142: FASTENING HOLE
150: GASKET
200: BATTERY MODULE
210: THERMAL BARRIER
300: LID BRACKET
400: CORNER BRACKET
500: FASTENING MEMBER
600: HEAT-RESISTANT SILICONE
610: BRAZING MATERIAL

## Claims

1. A pack case comprising:
a base plate having a bottom surface;
a plurality of side beams coupled along edges of a front side, a rear side, a left side, and a right side of the base plate to define an accommodation space;
a top cover coupled to the plurality of side beams to cover the accommodation space; and
a lid bracket coupled to the top cover and one side beam of the plurality of side beams.

2. The pack case of claim 1, wherein the lid bracket has a bent shape contacting both an edge of the top cover and upper corners of the one side beam.

3. The pack case of claim 2, wherein the lid bracket is provided in plurality to correspond to the plurality of side beams.

4. The pack case of claim 2, wherein the lid bracket is coupled to each of the top cover and the one side beam by a separable fastening member or by welding.

5. The pack case of claim 4, wherein the lid bracket is coupled to the one side beam with the top cover by the separable fastening member.

6. The pack case of claim 1, further comprising a gasket interposed between the plurality of side beams and the top cover.

7. The pack case of claim 1, further comprising a corner bracket coupled along a height direction at each corner where adjacent side beams of the plurality of side beams meet.

8. The pack case of claim 7, wherein the corner bracket has a bent shape that contacts the adjacent side beams of the plurality of side beams.

9. The pack case of claim 8, wherein each corner bracket is coupled to the adjacent side beams by a separable fastening member or by welding.

10. The pack case of claim 8, further comprising a heat-resistant silicone interposed between the adjacent side beams of the plurality of side beams.

11. The pack case of claim 7, further comprising a brazing material interposed between each corner bracket and each side beam.
